# EUROPEAN PATENT APPLICATION

(11) **EP 1 993 139 A2**
(43) Date of publication of application: **19.11.2008**
(21) Application number: 08156069.0
(22) Date of filing: 13.05.2008
(51) Int. Cl.: H01L 27/32, H01L 51/52

(54) **Organic light emitting device**

(30) Priority: 16.05.2007 KR 20070047849
(71) Applicant: Samsung SDI Co., Ltd., Suwon-si Gyeonggi-do (KR)
(72) Inventor: Chun, Min-Seung, Gyeonggi-do (KR); Lee, Kwan-Hee, Seoul 137-875 (KR); Kim, Mi-Kyung, Gyeonggi-do (KR); Kim, Dong-Hun, Gyeonggi-do (KR); Kwak, Jae-Hyun, Gyeonggi-do (KR); Son, Jung-Ha, Gyeonggi-do (KR)
(74) Representative: Hengelhaupt, Jürgen

(57) **Abstract**

Provided is an organic light emitting device including: a substrate (10); a first electrode (12); a second electrode (28); and an organic layer comprising a hole injection layer (16) and an emissive layer (22), and being disposed between the first electrode (12) and the second electrode (28), wherein the emissive layer (22) comprises a red emissive layer (22R), a green emissive layer (22G) and a blue emissive layer (22B), wherein the organic layer comprises at least one selected from a) a first auxiliary layer (18R) disposed between the hole injection layer (16) and the red emissive layer (22R) adapted to adjust a resonance cycle of a red light and b) a second auxiliary layer (18G) disposed between the hole injection layer (16) and the green emissive layer (22G) adapted to adjust a resonance cycle of a green light, wherein a material used to form the first auxiliary layer (18R) is different from a material used to form the hole injection layer (16), and a material used to form the second auxiliary layer (18G) is different from a material used to form the hole injection layer (16). The organic light emitting device has low turn-on voltage, high current density, high luminance, high current efficiency, high power, long life-time, and excellent color purity.

## Description

### BACKGROUND OF THE INVENTION

### 1. Field of the Invention

The present invention relates to an organic light emitting device, and more particularly, to an organic light emitting device that includes an auxiliary layer in order to adjust a resonance cycle of red light and/or green light. The organic light emitting device has improved electrical properties, for example, turn-on voltage, efficiency, life-time, and the like.

### 2. Description of the Related Art

Organic light emitting devices (OLEDs), which are self-emitting devices, have wide viewing angles, excellent contrast, quick response time, good operating voltage, and can realize multicolor images. Accordingly, much research has been conducted on the use of OLEDs in many commercial applications.

In general, an organic light emitting device has an anode/emissive layer/cathode structure. However, various other structures, such as an anode/hole transport layer/emissive layer/cathode structure, an anode/hole transport layer/emissive layer/electron injection layer/cathode structure or the like, can be obtained by additionally forming a hole injection layer, a hole transport layer, and an electron injection layer between the anode and emissive layer or between the emissive layer and cathode. An example of an organic light emitting device is disclosed in Korean Patent Publication No. 2005-0040960.

In spite of its advantages, the conventional organic light emitting device does not have a satisfactory turn-on voltage, light emitting efficiency, life-time properties, and the like. Therefore, there is a need for an organic light emitting device satisfying all these requirements.

### SUMMARY OF THE INVENTION

The present invention provides an organic light emitting device that includes an auxiliary layer in order to adjust a resonance cycle of red light and/or green light, thereby having high efficiency, long life-time, and the like.

According to an aspect of the present invention, there is provided an organic light emitting device comprising: a substrate; a first electrode; a second electrode; and an organic layer comprising a hole injection layer and an emissive layer and being disposed between the first electrode and the second electrode, wherein the emissive layer comprises a red emissive layer, a green emissive layer, and a blue emissive layer disposed adjacent to each other on the hole injection layer, wherein the organic layer comprises at least one selected from a) a first auxiliary layer disposed between the hole injection layer and the red emissive layer in order to adjust a resonance cycle of red light and b) a second auxiliary layer disposed between the hole injection layer and the green emissive layer in order to adjust a resonance cycle of green light, wherein a material used to form the first auxiliary layer is different from a material used to form the hole injection layer, and a material used to form the second auxiliary layer is different from a material used to form the hole injection layer.

The organic light emitting device has low turn-on voltage, high current density, high luminance, high current efficiency, high power, long life-time, and excellent color purity.

### BRIEF DESCRIPTION OF THE DRAWINGS

The above and other features and advantages of the present invention will become more apparent by describing in detail exemplary embodiments thereof with reference to the attached drawings in which:

FIG. 1 is a schematic cross-sectional view illustrating a structure of an organic light emitting device according to an embodiment of the present invention;

FIG. 2 is a graph showing accelerating life-time of an organic light emitting device of Example 1 and an organic light emitting device of Comparative Example 1;

FIG. 3 is a graph showing efficiencies of an organic light emitting device of Example 1 and an organic light emitting device of Comparative Example 1;

FIG. 4 is a graph showing accelerating life-time of an organic light emitting device of Example 2 and an organic light emitting device of Comparative Example 1;

FIG. 5 is a graph showing efficiencies of an organic light emitting device of Example 2 and an organic light emitting device of Comparative Example 1;

FIG. 6 is a graph showing accelerating life-time of an organic light emitting device of Example 3 and an organic light emitting device of Comparative Example 2;

FIG. 7 is a graph showing efficiencies of an organic light emitting device of Example 3 and an organic light emitting device of Comparative Example 2; and

FIG. 8 is a graph showing efficiencies of organic light emitting devices of Examples 4 and 5, and an organic light emitting device of Comparative Example 2.

### DETAILED DESCRIPTION OF THE INVENTION

The present invention will now be described more fully with reference to the accompanying drawings, in which exemplary embodiments of the invention are shown.

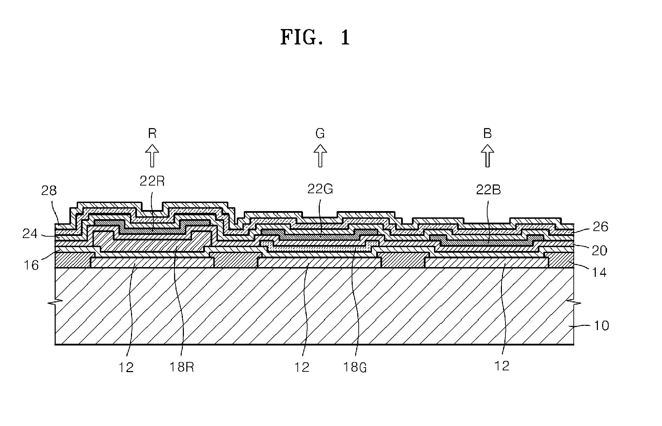

FIG. 1 is a schematic cross-sectional view of an organic light emitting device according to an embodiment of the present invention.

Referring to FIG. 1, an organic light emitting device includes a substrate 10, a first electrode 12, a hole injection layer 16, and a red emissive layer 22R, a green emissive layer 22G and a blue emissive layer 22B that are respectively patterned. A first auxiliary layer 18R is disposed between the hole injection layer 16 and the red emissive layer 22R in order to adjust a resonance cycle of red light. A second auxiliary layer 18G is disposed between the hole injection layer 16 and the green emissive layer 22G in order to adjust a resonance cycle of green light. A hole transport layer 20 is disposed on a lower portion of the red emissive layer 22R, the green emissive layer 22G, and the blue emissive layer 22B. An electron transport layer 24, an electron injection layer 26, and a second electrode 28 are disposed in this order on an upper portion of the red emissive layer 22R, the green emissive layer 22G, and the blue emissive layer 22B.

In FIG. 1, the substrate 10, which can be any substrate that is used in conventional organic light emitting devices, may be a glass substrate or a transparent plastic substrate that has excellent mechanical strength, thermal stability, transparency, and surface smoothness, can be easily treated, and is waterproof. Although not illustrated in FIG. 1, the organic light emitting device may further include a planarization film, an insulating layer, and the like on the substrate 10.

First electrodes 12 are disposed on the substrate 10. As illustrated in FIG. 1, the first electrodes 12 may be patterned according to red, green and blue sub pixels (R, G, B sub pixel), and may be an anode or a cathode. The first electrodes 12 may be a transparent electrode, a semi-transparent electrode, or a reflective electrode, and may be formed of ITO, IZO, SnO₂, ZnO, Al, Ag, Mg or the like, but the present invention is not limited thereto. In addition, various modifications such as a structure of at least two layers formed of at least two different materials, or the like are possible.

Insulating layers 14 are disposed on both edges of the first electrodes 12. The insulating layers 14, which may comprises a conventional insulating material, may be formed of an inorganic material such as SiO₂, SiNₓ or the like, an organic material such as a polyimide-based resin, an acryl-based resin or the like, or the like.

The hole injection layer 16 is formed on the first electrodes 12. The hole injection layer 16 may be formed as a common layer with respect to red, green, and blue sub pixels as illustrated in FIG. 1, rather than being independently formed according to red, green, and blue sub pixels. Thus, the manufacturing costs of the organic light emitting device can be reduced.

The hole injection layer 16 can be formed using various methods such as vacuum deposition, spin coating, casting, Langmuir Blodgett (LB), or the like.

When the hole injection layer 16 is formed by vacuum deposition, vacuum deposition conditions may vary according to the compound that is used to form the hole injection layer 16, and the desired structure and thermal properties of the hole injection layer 16 to be formed. In general, however, the vacuum deposition may be performed at a deposition temperature of 100-500°C, a pressure of 10⁻⁸ -10⁻³ torr, and a deposition speed of 0.01-100 Å/sec.

When the hole injection layer 16 is formed by spin coating, coating conditions may vary according to the compound that is used to form the hole injection layer 16, and the desired structure and thermal properties of the hole injection layer 16 to be formed. In general, however, the coating speed may be in the range of about 2,000-5,000 rpm, and a temperature for heat treatment, which is performed to remove a solvent after coating, may be in the range of about 80-200°C.

A material of the hole injection layer may have a HOMO energy level of -4.5 eV to -5.5 eV, and preferably -4.9 eV to -5.2 eV. When the hole injection layer is formed of a material having a HOMO energy level beyond the range described above, it is difficult to control a charge balance.

More particularly, the material used to form the hole injection layer may be a phthalocyanine compound, such as copperphthalocyanine disclosed in US 4,356,429 A; a star-burst type amine derivative, such as TCTA, m-MTDATA, or m-MTDAPB, disclosed in Advanced Material, 6, pp. 677 (1994); soluble and conductive polymer such as polyaniline/Dodecylbenzenesulfonic acid (PANI/DBSA); poly(3,4-ethylenedioxythiophene)/poly(4-styrenesulfonate) (PEDOT/PSS); polyaniline/camphor sulfonic acid (Pani/CSA); (polyaniline)/poly(4-styrenesulfonate) (PANI/PSS); LHT-100 obtained from LUDIS; or the like, but is not limited thereto.

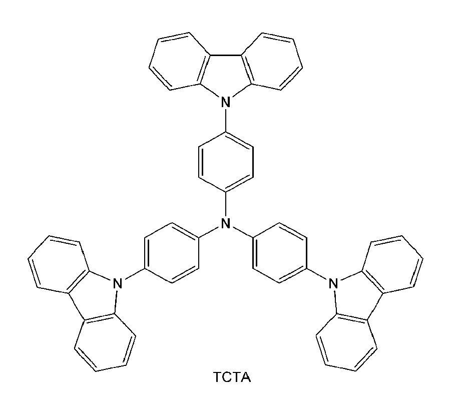

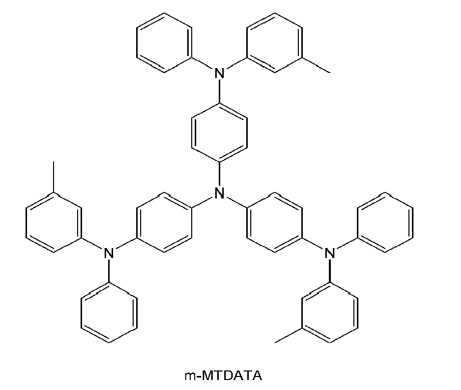

The thickness of the hole injection layer may be in the range of 10-200 nm, and preferably, in the range of 60-150 nm. The thickness of the hole injection layer may be selected in these ranges taking into consideration the processing time and manufacturing costs.

The first auxiliary layer 18R is formed on a portion of the hole injection layer 16 which corresponds to a red subpixel, and the second auxiliary layer 18G is formed on a portion of the hole injection layer 16 which corresponds to a green subpixel. The first auxiliary layer 18R adjusts a thickness of an organic layer of the red subpixel in order to control a resonance cycle of red light. The second auxiliary layer 18G adjusts a thickness of an organic layer of the green subpixel in order to control a resonance cycle of green light.

Red light, green light, and blue light that are emitted from the organic layers formed between the first electrodes 12 and a second electrode 28 resonate between the first electrodes 12 and the second electrode 28 to then be ejected to the outside of the organic light emitting device. At this time, when the light resonating between the first electrodes 12 and the second electrode 28 generates a constructive interference, the light emitting efficiency, luminance, and the like of the organic light emitting device may further be improved. However, each of the red light, the green light, and the blue light has a different wavelength (red light wavelength>green light wavelength>blue light wavelength). Thus, a resonance distance needed for the generation of optical constructive interference (a distance between the first electrode 12 and the second electrode 28, each of the resonance distances of the red light, the green light and the blue light corresponds to the thickness of organic layers of red subpixel, green subpixel and blue subpixel) is different according to each color.

As described above, the hole injection layer 16 may be formed as a common layer with respect to each of the red, green, and blue subpixels in order to improve the manufacturing efficiency as illustrated in FIG. 1. At this time, the thickness of the hole injection layer 16 is conventionally adjusted to generate an optical constructive interference with respect to the blue light by taking into consideration the wavelength of the blue light which is the shortest wavelength among the red, green and blue lights in order to adjust a resonance cycle of the blue light. In this case, the light emitting efficiency, the color coordinate, and the like of the red light and the green light can lead to loss. To compensate for the loss, that is, to adjust the thickness of the organic layers of the red subpixel and the green subpixel so that even the red light and the green light generate an optical constructive interference, the first auxiliary layer 18R and the second auxiliary layer 18G may be formed to correspond to the red subpixel and the green subpixel, respectively, as illustrated in FIG.1.

A material used to form the first auxiliary layer 18R may be differently selected from a material used to form the hole injection layer 16 in order to improve the light emitting efficiency, the color purity, and the like of the red light. For example, a HOMO energy level of the material used to form the first auxiliary layer 18R may be within ±0.5 eV of a HOMO energy level of the material used to form the hole injection layer 16, preferably ±0.3 eV thereof. When the HOMO energy level of the material used to form the first auxiliary layer 18R is outside these ranges described above, the light emitting efficiency, the color purity, and the like of the red light can not be optimized. For example, when LHT-001 obtained from LUDIS is selected as the material used to form the hole injection layer 16, a material having a HOMO energy level of about -5.6 to -4.6 eV may be selected as the material used to form the first auxiliary layer 18R since the HOMO energy level of LHT-001 of LUDIS is about -5.1 eV.

A hole mobility of the material used to form the first auxiliary layer 18R may be as 1.5-2 times as that of 4,4'-bis[N-(1-naphthyl)-N-phenylamino]biphenyl (NPB). The hole mobility of NPB varies according to the measurement conditions (temperature, applied electric field and the like) and measurement methods, but may be approximately 2.3 X 10⁻³ cm²/V.s (under a condition of 4 X 10⁵V/cm). For example, the hole mobility of the material used to form the first auxiliary layer 18R may be in the range of 3.45 X10⁻³ to 4.6 X 10⁻³ cm²/V.s, but is not limited thereto, taking into consideration that the hole mobility of NPB can vary according to the measurement conditions and methods.

The thickness of the first auxiliary layer 18R may be in the range of 60-100 nm, preferably 70-90 nm. When the thickness of the first auxiliary layer 18R is outside these ranges described above, it is difficult to adjust the resonance cycle of the red light. Thus, red light having excellent light emitting efficiency, long life-time, high color purity, and the like can not be obtained.

On the other hand, a material used to form the second auxiliary layer 18G may be differently selected from the material used to form the hole injection layer 16 in order to improve the light emitting efficiency, the color purity, and the like of the green light. For example, a HOMO energy level of the material used to form the second auxiliary layer 18G may be within ±0.5 eV of a HOMO energy level of the material used to form the hole injection layer 16, preferably ±0.3 eV thereof. When the HOMO energy level of the material used to form the second auxiliary layer 18G is outside these ranges described above, the light emitting efficiency, the color purity, and the like of the green light can not be optimized. For example, when LHT-001 obtained from LUDIS is selected as the material used to form the hole injection layer 16, a material having a HOMO energy level of about -5.6 to -4.6 eV may be selected as the material used to form the second auxiliary layer 18G since the HOMO energy level of LHT-001 of LUDIS is about -5.1 eV.

A hole mobility of the material used to form the second auxiliary layer 18G may be as 1.5-2 times as that of 4,4'-bis[N-(1-naphthyl)-N-phenylamino]biphenyl (NPB). The hole mobility of NPB varies according to the measurement conditions (temperature, applied electric field and the like) and measurement methods, but may be approximately 2.3 X 10⁻³ cm²/V.s (under the condition of 4 X 10⁵V/cm). For example, the hole mobility of the material used to form the second auxiliary layer 18G may be in the range of 3.45 X10⁻³ to 4.6 X 10⁻³ cm²/V.s, but is not limited thereto, taking into consideration that the hole mobility of NPB can vary according to the measurement conditions and methods.

The thickness of the second auxiliary layer 18G may be in the range of 20-60 nm, preferably 30-50 nm. When the thickness of the second auxiliary layer 18G is outside these ranges described above, it is difficult to adjust the resonance cycle of the green light. Thus, green light having excellent light emitting efficiency, long life-time, high color purity, and the like can not be obtained.

The materials used to form the first auxiliary layer 18R and the second auxiliary layer 18G can be the same or different from each other, as long as are different from the material used to form the hole injection layer 16.

More particularly, the materials used to form the first auxiliary layer 18R and the second auxiliary layer 18G may be a compound represented by Formula 1 below: 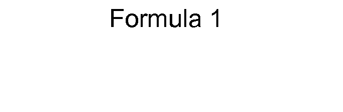 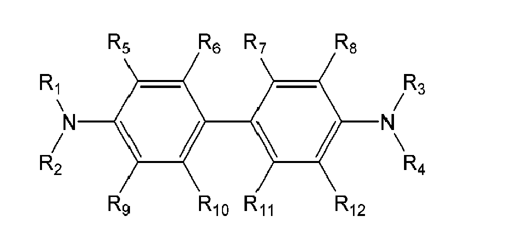 where R₁ through R₁₂ are each independently a hydrogen atom, a hydroxyl group, a cyano group, a substituted or unsubstituted C₁-C₃₀ alkyl group (preferably, a substituted or unsubstituted C₁-C₁₀ alkyl group), a substituted or unsubstituted C₁-C₃₀ alkoxy group (preferably, a substituted or unsubstituted C₁-C₁₀ alkoxy group), a substituted or unsubstituted C₂-C₃₀ alkenyl group (preferably, a substituted or unsubstituted C₂-C₁₀ alkenyl group), a substituted or unsubstituted C₂-C₃₀ alkynyl group (preferably, a substituted or unsubstituted C₂-C₁₀ alkynyl group), a substituted or unsubstituted C₆-C₃₀ aryl group (preferably, a substituted or unsubstituted C₆-C₂₀ aryl group), a substituted or unsubstituted C₃-C₃₀ heteroaryl group (preferably, a substituted or unsubstituted C₃-C₂₀ heteroaryl group) or a group represented by Formula -N(A₁)(A₂). In Formula -N(A₁)(A₂), A₁ and A₂ are each independently a substituted or unsubstituted C₆-C₃₀ aryl group (preferably, a substituted or unsubstituted C₆-C₂₀ aryl group), a substituted or unsubstituted C₃-C₃₀ heteroaryl group (preferably, a substituted or unsubstituted C₃-C₂₀ heteroaryl group). At least one hydrogen atom of these aryl groups and hetero aryl groups may be substituted with the same substituent as in the case of the substituted C₁-C₃₀ alkyl group as described below.

Examples of the unsubstituted C₁-C₃₀ alkyl group of Formula 1 include methyl, ethyl, propyl, isobutyl, sec-butyl, pentyl, iso-amyl, hexyl and the like. At least one hydrogen atom of the C₁-C₃₀ alkyl group may be substituted with a halogen atom, a hydroxyl group, a nitro group, a cyano group, an amino group, an amidino group, hydrazine, hydrazone, a carboxyl group or a salt thereof, a sulfonic acid group or a salt thereof, a phosphoric acid or a salt thereof, a C₁-C₃₀ alkyl group, a C₁-C₃₀ alkenyl group, a C₁-C₃₀ alkynyl group, a C₆-C₃₀ aryl group, a C₇-C₂₀ arylalkyl group, a C₂-C₂₀ heteroaryl group, a C₃-C₃₀ heteroarylalkyl group, a C₆-C₃₀ aryloxy group or a compound represented by Formula -N(Z₁)(Z₂). In Formula -N(Z₁)(Z₂), Z₁ and Z₂ may be each independently selected from the group consisting of a hydrogen atom, a substituted or unsubstituted C₁-C₃₀ alkyl group, a substituted or unsubstituted C₆-C₃₀ aryl group, and a substituted or unsubstituted C₂-C₃₀ heteroaryl group.

The unsubstituted C₁-C₃₀ alkoxy group of Formula 1 is a group represented by -OX, where X is an alkyl group as described above. Examples of the unsubstituted C₁-C₃₀ alkoxy group include methoxy, ethoxy, phenyloxy, cyclohexyloxy, naphthyloxy, isopropyloxy, diphenyloxy, and the like. At least one hydrogen atom of these alkoxy groups can be substituted with the same substituent as in the case of the substituted C₁-C₃₀ alkyl group described above.

The unsubstituted C₂-C₃₀ alkenyl group of Formula 1 refers to a group containing at least one carbon-carbon double bond in the middle or the endmost part of the alkyl group as defined above, for example, ethylene, propylene, butylenes, hexylene and the like. At least one hydrogen atom of these alkenyl groups can be substituted with the same substituent as in the case of the substituted C₁-C₃₀ alkyl group described above.

The unsubstituted C₂-C₃₀ alkynyl group of Formula 1 refers to a group containing a carbon-carbon triple bond at a middle or the endmost part of the alkyl group as defined above. Examples of the unsubstituted C₂-C₃₀ alkynyl group include acetylene, propylene, phenylacetylene, naphthylacetylene, isopropylacetylene, t-butylacetylene, diphenylacetylene and the like. At least one hydrogen atom of these alkynyl groups can be substituted with the same substituent as in the case of the substituted C₁-C₃₀ alkyl group described above.

The unsubstituted C₆-C₃₀ aryl group of Formula 1 refers to a C₆-C₃₀ carbocyclic aromatic system containing at least one aromatic ring. The at least one aromatic ring may be fused with each other, or bound to each other by a single bond or the like. At least one hydrogen atom of the aryl group can be substituted with the same substituent as in the case of the substituted C₁-C₃₀ alkyl group described above.

In Formula 1, examples of the substituted or unsubstituted C₆-C₃₀ aryl group include a phenyl group, a C₁-C₁₀ alkylphenyl group (for example, an ethylphenyl group), a halophenyl group (for example, o-, m- and p-fluorophenyl groups, a dichlorophenyl group), a cyanophenyl group, a dicyanophenyl group, a trifluoromethoxyphenyl group, a biphenyl group, a halobiphenyl group, a cyanobiphenyl group, a C₁-C₁₀ biphenyl group, a C₁-C₁₀ alkoxybiphenyl group, o-, m-, and p-tolyl groups, o-, m-, and p-cumenyl groups, a mesityl group, a phenoxyphenyl group, an (α,α-dimethylbenzene)phenyl group, an (N,N'-dimethyl)aminophenyl group, an (N,N'-diphenyl)aminophenyl group, a pentalenyl group, an indenyl group, a naphthyl group, a halonaphthyl group (for example, a fluoronaphthyl group), a C₁-C₁₀ alkylnaphthyl group (for example, a methyl naphthyl group), a C₁-C₁₀ alkoxynaphthyl group (for example, a methoxynaphthyl group), a cyanonaphthyl group, an anthracenyl group, an azulenyl group, a heptalenyl group, an acenaphthylenyl group, a phenalenyl group, a fluorenyl group, an anthraquinolyl group, a methylanthryl group, a phenanthrenyl group, a triphenylenyl group, a pyrenyl group, a chrysenyl group, an ethyl-chrysenyl group, a picenyl group, a perylenyl group, a chloroperylenyl group, a pentaphenyl group, a pentacenyl group, tetraphenylenyl group, hexaphenyl group, hexacenyl group, rubicenyl group, a coronenyl group, a trinaphthylenyl group, a heptaphenyl group, a heptacenyl group, a pyranthrenyl group, an ovalenyl group and the like.

The unsubstituted C₃-C₃₀ heteroaryl group of Formula 1 refers to a system comprising at least one aromatic ring, which comprises at least one hetero atom selected from N, O, P and S and the remaining ring atom is carbon (C). The at least one aromatic ring may be fused with each other, or bound to each other by a single bond or the like. At least one hydrogen atom of the heteroaryl group can be substituted with the same substituent as in the case of the substituted C₁-C₃₀ alkyl group described above.

Examples of the unsubstituted C₃-C₃₀ heteroaryl group of Formula 1 include a pyrazolyl group, an imidazolyl group, an oxazolyl group, a thiazolyl group, a triazolyl group, a tetrazolyl group, an oxadiazolyl group, a pyridinyl group, a pyridazinyl group, a pyrimidinyl group, a triazinyl group, a carbazolyl group, an indolyl group, a quinolinyl group, an isoquinolinyl group and the like. This unsubstituted C₃-C₃₀ heteroaryl group can be substituted with the same substituent as in the case of the substituted C₁-C₃₀ alkyl group described above.

Preferably, R₁ through R₁₂ are each independently a hydrogen atom, a phenyl group, a (N,N'-diphenyl)aminophenyl group, a naphthyl group, an anthracenyl group, or N-phenylcarbazolyl.

The first auxiliary layer 18R and the second auxiliary layer 18G may be formed using various methods such as vacuum deposition, spin coating, casting, Langmuir Blodgett (LB), or the like. When the first auxiliary layer 18R and the second auxiliary layer 18G are formed by vacuum deposition and spin coating, the vacuum deposition conditions and coating conditions may vary according to the compound that is used to form the first auxiliary layer 18R and the second auxiliary layer 18G. However, in general, the deposition and coating conditions may be in almost the same condition ranges as in the formation of the hole injection layer 16.

A hole transport layer 20 is formed on the first auxiliary layer 18R, the second auxiliary layer 18G, and the hole injection layer 16. That is, the hole transport layer 20 is also formed on the hole injections layer 16 in the blue pixel region.

The hole transport layer 20 may be formed using various methods such as vacuum deposition, spin coating, casting, Langmuir Blodgett (LB), or the like. When the hole transport layer 20 is formed by vacuum deposition and spin coating, vacuum deposition conditions and coating conditions may vary according to the compound that is used to form the hole transport layer 20. However, in general, the deposition and coating conditions may be in almost the same condition ranges as in the formation of the hole injection layer 16.

A known hole transporting material may be used as the material used to form the hole transport layer. Examples of the hole transporting material include a carbazole derivative such as N-phenylcarbazole, polyvinylcarbazole and the like, a conventional amine derivative having an aromatic condensation ring, such as 4,4'-bis[N-(1-naphthyl)-N-phenylamino]biphenyl (NPB), N,N'-bis(3-methylphenyl)-N,N' -diphenyl-[1,1-biphenyl]-4,4'-diamine (TPD), N,N'-di(naphthalene-1-yl)-N,N'-diphenyl benzidine (α-NPD) and the like, and the like, but are not limited thereto.

The thickness of the hole transport layer 20 may be in the range of about 15-100 nm, preferably 20-70 nm, since excellent hole transporting properties and low turn-on voltage can be obtained.

Next, a red emissive layer 22R, a green emissive layer 22G and a blue emissive layer 22B are formed on the hole transport layer 20 according to each subpixel. The red emissive layer 22R, the green emissive layer 22G and the blue emissive layer 22B may be formed using methods such as vacuum deposition, spin coating, casting, Langmuir Blodgett (LB), or the like. When the red, green and blue emissive layers 22R, 22G, and 22B are formed by vacuum deposition and spin coating, vacuum deposition conditions and coating conditions vary according to a compound that is used to form the emissive layers. However, in general, the deposition and coating conditions may be in almost the same condition ranges as in the formation of the hole injection layer 16.

The emissive layers may be formed using known various light emitting materials such as known hosts and dopants. As for the dopant, both known fluorescent dopant and known phosphorescent dopant can be used.

For example, the known hosts can be Alq₃, 4,4'-N,N'-dicarbazole-biphenyl (CBP), poly(n-vinylcarbazol (PVK), distyrylarylene (DSA), GDI1403 obtained from Gracel company (red phosphorescent host), GGH01 obtained from Gracel company (green fluorescent host) and the like, but are not limited thereto.

Examples of the fluorescent dopant may include IDE102, IDE105 and IDE118 obtained from Idemitsu Co. In addition, examples of a phosphorescent dopant may include Ir(ppy)₃ (ppy= phenylpyridine) (green), a green fluorescent dopant GD01 obtained from Gracel company, (4,6-F2ppy)₂lrpic (reference: Chihaya Adachi etc. Appl. Phys. Lett., 79, 2082-2084, 2001), TEB002 obtained from Covion company, platinum(II) octaethylporphyrin (PtOEP), compounds represented by Formula 2 below (refer to Korean Patent Publication No. 2005-0078472), Firpric, tris(1-phenylisoquinoline) iridium (III) (Ir(piq)₃), but are not limited thereto.

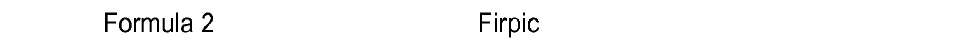

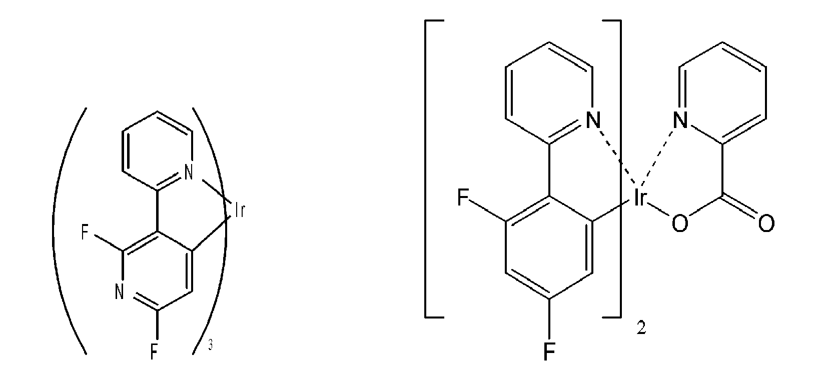

An amount of the dopant may be 0.1-20 parts by weight based on 100 parts by weight (that is, a total weight of the host and dopant is 100 parts by weight) of a material used to form an emissive layer, preferably 0.5-15 parts by weight. When the amount of the dopant is less than 0.1 parts by weight based on 100 parts by weight of a material used to form an emissive layer, the effect accruing from the addition of the dopant is insignificant. When the amount of the dopant is greater than 20 parts by weight based on 100 parts by weight of a material used to form an emissive layer, concentration quenching may occur in both cases of the phosphorescent and fluorescent dopants.

The thickness of the emissive layer may be in the range of about 10-100 nm, and preferably, in the range of 10-60 nm. When the thickness of the emissive layer is greater than 10 nm, an excellent emissive ability of the emissive layer can be obtained. When the thickness of the emissive layer is less than 100 nm, an increasing of a turn-on voltage of the organic light emitting device can be substantially prohibited.

When the emissive layer includes a phosphorescent dopant, a hole blocking layer (HBL) can be formed on the emissive layer in order to prevent triplet exitons or holes from migrating into an electron transport layer (not shown in FIG. 1). A material used to form the HBL is not particularly limited, and can be any known material used to form an HBL. Examples of the material include oxadiazol derivatives, triazol derivatives, phenanthroline derivatives, a hole blocking material disclosed in JP 11-329734(A1), Balq, BCP, and the like.

The thickness of the HBL may be in the range of about 5-100 nm, and preferably, in the range of 10-30 nm. When the thickness of the HBL is greater than 5 nm, a hole blocking ability can be effectively obtained. When the thickness of the HBL is less than 100 nm, an increasing of a turn-on voltage of the organic light emitting device can be substantially prohibited.

The device may further comprise an electron blocking layer (not shown in FIG. 1).

Then, an electron transport layer (ETL) 24 is formed on the emissive layer. The ETL 24 may be formed using various methods such as vacuum deposition, spin coating, casting, or the like. When the ETL 24 is formed by vacuum deposition or spin coating, the conditions for deposition and coating are, in general, similar to those for the formation of the hole injection layer 16, although the conditions for the deposition and coating conditions may vary according to the material that is used to form the ETL 24.

The material used to form the ETL is not particularly limited, and may be selected from known electron transporting materials. Examples of the material include a quinoline derivative, in particular, tris(8-quinolinorate)aluminum (Alq₃), TAZ, or the like, which are known in the art.

The thickness of the ETL 24 may be in the range of about 10-100 nm, and preferably, 10-50 nm. When the thickness of the ETL 24 is greater than 10 nm, an electron transporting ability can be effectively obtained. When the thickness of the ETL 24 is less than 100 nm, an increasing of a turn-on voltage of the organic light emitting device can be substantially prohibited.

In addition, an electron injection layer (EIL) 26 that makes it easy for electrons to be injected from a cathode may be formed on the ETL 24. The EIL 26 may be formed using various methods such as vacuum deposition, spin coating, casting, or the like. When the EIL 26 is formed by vacuum deposition or spin coating, the conditions for deposition and coating are, in general, similar to those for the formation of the hole injection layer 16, although the conditions for the deposition and coating conditions may vary according to the material that is used to form the EIL 26.

The EIL 26 may be formed of an electron injecting material such as LiF, NaCl, CsF, Li₂O, BaO, or the like, which is known in the art. The thickness of the EIL 26 may be in the range of about 0.1-10 nm, and preferably, 0.5-9 nm. When the thickness of the EIL 26 is greater than 0.1 nm, an electron injecting ability can be effectively obtained. When the thickness of the EIL 26 is less than 10 nm, an increasing of a turn-on voltage of the organic light emitting device can be substantially prohibited.

Finally, a second electrode 28 is formed on the EIL 26. The second electrode 28 may be formed by vacuum deposition, sputtering or the like, and may be a cathode or an anode. The second electrode may be formed of a low work-function metal, an alloy, an electrically conductive compound, or a combination thereof. In particular, the second electrode may be formed of Li, Mg, Al, Al-Li, Ca, Mg-In, Mg-Ag, or the like. In addition, various modifications such as a structure of at least two layers formed of at least two different materials or the like are possible.

An organic light emitting device according to the present invention has been described with reference to FIG. 1 illustrating a structure of an organic light emitting device, but the present is not limited thereto and various modifications are possible.

Hereinafter, the present invention will be described more specifically with respect to the following Examples. However, the Examples are provided only for illustration purposes and do not limit the scope of the present invention.

### Example 1

As an anode, a 15 Ω/cm² ITO glass substrate (thickness: 1200 A) was cut to a size of 50 mm x 50 mm x 0.7 mm, microwave-washed with isopropyl alcohol and pure water for 5 minutes, respectively. The ITO glass substrate was irradiated with ultraviolet rays for 30 minutes and washed with ozone, and then installed in a vacuum deposition device.

A hole injecting material (Product name: LHT-001) obtained from LUDIS was vacuum-deposited on the glass substrate to form a hole injection layer having a thickness of 130 nm. Subsequently, a hole transporting material (Product name: IDE-406) obtained from Idemitsu Co. was vacuum-deposited to form a first auxiliary layer having a thickness of 80 nm. 4,4'-bis[N-(1-naphthyl)-N-phenylamino] biphenyl (NPB) was then vacuum-deposited on the first auxiliary layer to form a hole transport layer having a thickness of 20 nm.

A known red phosphorescent host GD11403 obtained from Gracel company and a known red phosphorescent dopant Ir(piq)₃ (dopant amount: 15 wt%) were co-deposited on the hole transport layer to form a red phosphorescent emissive layer having a thickness of 20 nm.

Subsequently, Alq₃ was vacuum-deposited on the emissive layer to form an electron transport layer having a thickness of 30 nm. LiF was then vacuum-deposited on the electron transport layer to form an electron injection layer having a thickness of 0.5 nm, and Mg:Ag was vacuum-deposited to a thickness of 16 nm to form a cathode layer and thus manufacture an organic light emitting device.

### Example 2

An organic light emitting device was manufactured in the same manner as in Example 1, except that HTM016 obtained from Merck was used instead of IDE406 obtained from Idemitsu Co. in the process of forming a first auxiliary layer.

### Comparative Example 1

An organic light emitting device was manufactured in the same manner as in Example 1, except that LHT-001 used to form the hole injection layer was used instead of IDE406 obtained from Idemitsu Co. in the process of forming a first auxiliary layer.

### Evaluation Example 1

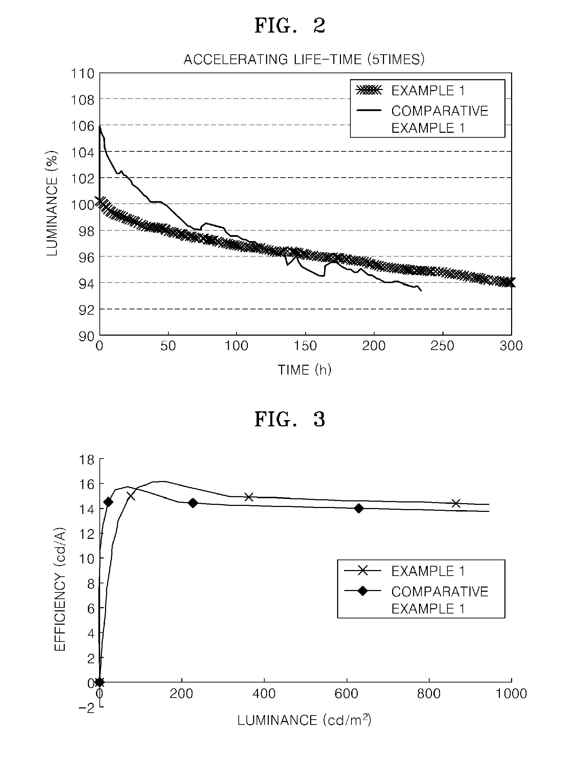

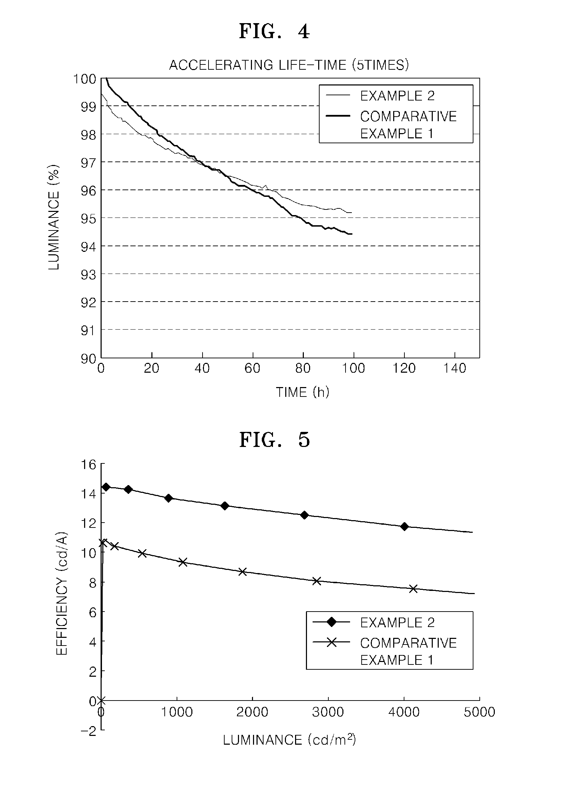

Turn-on voltages, current densities, luminances, current efficiencies, powers, and color coordinates of the organic light emitting devices of Examples 1 and 2 and Comparative Example 1 were evaluated using PR650 (Spectroscan spectrometer, PHOTO RESEARCH INC.). The results are shown in Table 1 below. In addition, accelerating life-time (5 times) data of the organic light emitting devices of Example 1 and Comparative Example 1 are shown in FIG. 2, and current efficiency data thereof are shown in FIG. 3. In addition, accelerating life-time (5 times) data of the organic light emitting devices of Example 2 and Comparative Example 1 are shown in FIG. 4, and current efficiency data thereof are shown in FIG. 5.

**Table 1**

| | Example 1 | Example 2 | Comparative Example 1 |
|---|---|---|---|
| Turn-on voltage (V) | 3.437 | 3.425 | 4.137 |
| Current density (mA/cm2) | 5.559 | 5.832 | 5.831 |
| Luminance (cd/m2) | 800 | 800 | 800 |
| Current efficiency (cd/A) | 14.423 | 13.761 | 13.796 |
| Power (Im/W) | 13.227 | 12.670 | 10.513 |
| X coordinate | 0.682 | 0.684 | 0.681 |
| Y coordinate | 0.317 | 0.314 | 0.318 |

Referring to Table 1, it can be seen that the organic light emitting devices of Examples 1 and 2 have better turn-on voltage, current density, lumance, current efficiency, power, color purity, and the like, compared to the organic light emitting device of Comparative Example 1. In addition, referring to FIGS. 2 and 4, it can be seen that the organic light emitting devices of Examples 1 and 2 have longer life-time than the organic light emitting device of Comparative Example 1.

### Example 3

As an anode, a 15 Ω/cm² ITO glass substrate (thickness: 1200 A) was cut to a size of 50 mm x 50 mm x 0.7 mm, microwave-washed with isopropyl alcohol and pure water for 5 minutes, respectively. The ITO glass substrate was irradiated with ultraviolet rays for 30 minutes and washed with ozone, and then installed in a vacuum deposition device.

A hole injecting material (Product name: LHT-001) obtained from LUDIS was vacuum-deposited on the glass substrate to form a hole injection layer having a thickness of 130 nm. Subsequently, a hole transporting material (Product name: IDE-406) obtained from Idemitsu Co. was vacuum-deposited to form a second auxiliary layer having a thickness of 40 nm. 4,4'-bis[N-(1-naphthyl)-N-phenylamino] biphenyl (NPB) was then vacuum-deposited on the second auxiliary layer to form a hole transport layer having a thickness of 20 nm.

A known green fluorescent host GGH01 obtained from Gracel company and a known green fluorescent dopant GD01 (dopant amount: 15 wt%) were co-deposited on the hole transport layer to form a green fluorescent emissive layer having a thickness of 20 nm.

Subsequently, Alq₃ was vacuum-deposited on the emissive layer to form an electron transport layer having a thickness of 30 nm. LiF was then vacuum-deposited on the electron transport layer to form an electron injection layer having a thickness of 0.5 nm, and Mg:Ag was vacuum-deposited to a thickness of 16 nm to manufacture an organic light emitting device.

### Example 4

An organic light emitting device was manufactured in the same manner as in Example 3, except that HTM016 obtained from Merck was used instead of IDE406 obtained from Idemitsu Co. in the process of forming a second auxiliary layer.

### Example 5

An organic light emitting device was manufactured in the same manner as in Example 3, except that ELM307 obtained from ELM was used instead of IDE406 obtained from Idemitsu Co. in the process of forming a second auxiliary layer.

### Comparative Example 2

An organic light emitting device was manufactured in the same manner as in Example 3, except that LHT-001 used to form the hole injection layer was used instead of IDE406 obtained from Idemitsu Co. in the process of forming a second auxiliary layer.

### Evaluation Example 2

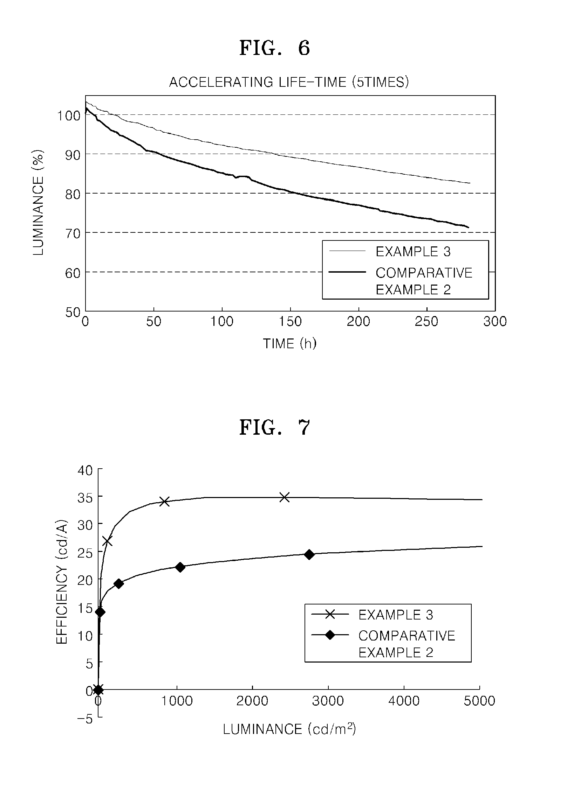

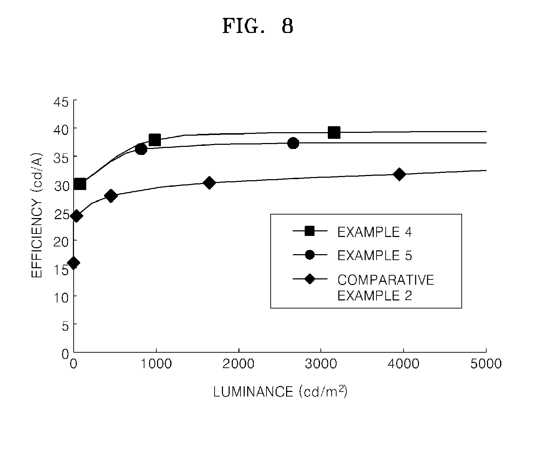

Turn-on voltages, current densities, luminances, current efficiencies, powers, and color coordinates of the organic light emitting devices of Examples 3, 4 and 5 and Comparative Example 2 were evaluated using PR650 (obtained from Spectroscan spectrometer, PHOTO RESEARCH INC.). The results are shown in Table 2 below. In addition, accelerating life-time (5 times) data of the organic light emitting devices of Example 3 and Comparative Example 2 are shown in FIG. 6, and current efficiency data thereof are shown in FIG. 7. In addition, current efficiency data of the organic light emitting devices of Examples 4 and 5 and Comparative Example 2 are shown in FIG. 8.

**Table 2**

| | Example 3 | Example 4 | Example 5 | Comparative Example 2 |
|---|---|---|---|---|
| Turn-on voltage (V) | 3.8 | 3.7 | 3.8 | 4.2 |
| Current density (mA/cm2) | 5.5 | 4.9 | 5.1 | 8.0 |
| Luminance (cd/m2) | 1900 | 1900 | 1900 | 1900 |
| Current efficiency (cd/A) | 34.3 | 38.4 | 36.7 | 23.2 |
| Power (Im/W) | 28.2 | 32.6 | 30.5 | 17.2 |
| X coordinate | 0.213 | 0.234 | 0.214 | 0.216 |
| Y coordinate | 0.731 | 0.721 1 | 0.730 | 0.730 |

Referring to Table 2, it can be seen that the organic light emitting devices of Examples 3, 4 and 5 have better turn-on voltage, current density, lumance, current efficiency, power, color purity, and the like, compared to the organic light emitting device of Comparative Example 2. In addition, referring to FIG. 6, it can be seen that the organic light emitting device of Example 3 has longer life-time than the organic light emitting device of Comparative Example 2.

As describe above, the organic light emitting device according to the present invention includes an auxiliary layer formed corresponding to a red subpixel and/or a green subpixel in order to adjust a resonance cycle of red light and/or green light. The auxiliary layer comprises a material different from a material used to form a hole injection layer in order to improve the efficiency, color purity, and the like of each of the red light and/or green light, and thereby the organic light emitting device has high efficiency, low turn-on voltage, high luminance, and long life-time.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An organic light emitting device comprising:
a substrate (10);
a first electrode (12);
a second electrode (28); and
an organic layer being disposed between the first electrode (12) and the second electrode (28), and comprising a hole injection layer (16) and an emissive layer (22),
wherein the emissive layer (22) comprises a red emissive layer (22R), a green emissive layer (22G), and a blue emissive layer (22B) being disposed adjacent to one another,
wherein the organic layer comprises at least one selected from a) a first auxiliary layer (18R) disposed between the hole injection layer (16) and the red emissive layer (22R) adapted to adjust a resonance cycle of red light and b) a second auxiliary layer (18G) disposed between the hole injection layer (16) and the green emissive layer (22G) adapted to adjust a resonance cycle of green light,
wherein a material used to form the first auxiliary layer (18R) is different from a material used to form the hole injection layer (16), and a material used to form the second auxiliary layer (18G) is different from a material used to form the hole injection layer (16).

2. The organic light emitting device of claim 1, wherein a highest occupied molecular orbital (HOMO) energy level of the material used to form the hole injection layer (16) is in the range of -4.5 to -5.5 eV, in particular in the range of -4.9 to -5.2 eV.

3. The organic light emitting device of claim 1 or 2, wherein the material used to form the hole injection layer (16) is a phthalocyanine compound, TCTA, m-MTDATA, m-MTDAPB, polyaniline/Dodecylbenzenesulfonic acid (PANI/DBSA); poly(3,4-ethylenedioxythiophene)/poly(4-styrenesulfonate) (PEDOT/PSS); polyaniline/camphor sulfonic acid (Pani/CSA); and (polyaniline)/poly(4-styrenesulfonate) (PANI/PSS).

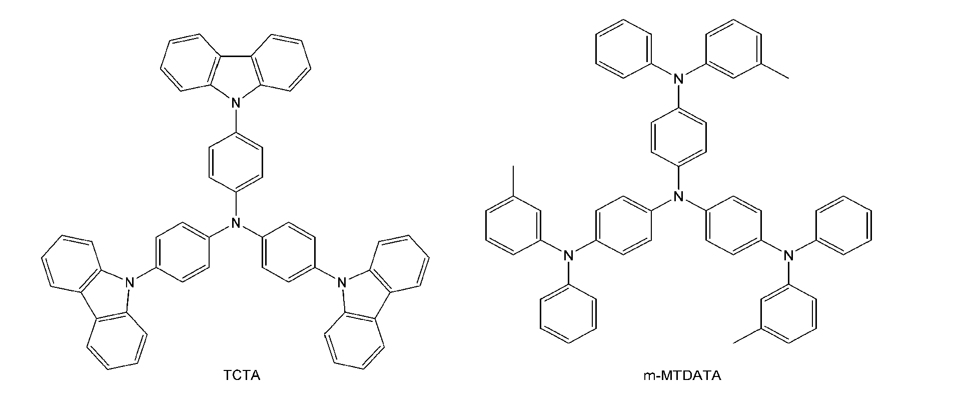

4. The organic light emitting device of one of the preceding claims, wherein the thickness of the hole injection layer (16) is in the range of 10-200 nm, in particular 60-150 nm.

5. The organic light emitting device of one of the preceding claims, wherein a HOMO energy level of the material used to form the first auxiliary layer (18R) and/or the second auxiliary layer (18G) is within ±0.5 eV of a HOMO energy level of the material used to form the hole injection layer (16), in particular within ±0.3 eV of the HOMO energy level of the material used to form the hole injection layer.

6. The organic light emitting device of one of the preceding claims, wherein a hole mobility of the material used to form the first auxiliary layer (18R) and/or the second auxiliary layer (18G) is 1.5-2 times that of 4,4'-bis[N-(1-naphthyl)-N-phenylamino]biphenyl (NPB).

7. The organic light emitting device of one of the preceding claims, wherein the thickness of the first auxiliary layer (18R) is in the range of 60-100 nm, in particular 70-90 nm.

8. The organic light emitting device of one of the preceding claims, wherein the thickness of the second auxiliary layer (18G) is in the range of 20-60 nm, in particular 30-50 nm.

9. The organic light emitting device of one of the preceding claims, wherein the material used to form the first auxiliary layer (18R) is the same as that used to form the second auxiliary layer (18G).

10. The organic light emitting device of one of the preceding claims, wherein the materials used to form the first auxiliary layer (18R) and the second auxiliary layer (18G) are independently compounds represented by Formula 1 below: 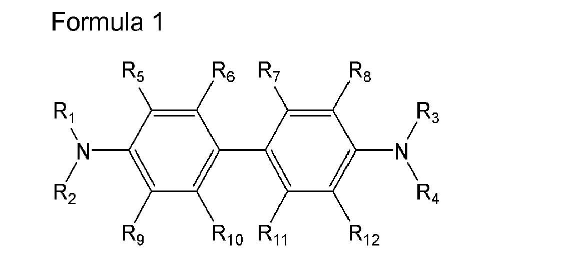 where R₁ through R₁₂ are each independently a hydrogen atom, a hydroxyl group, a cyano group, a substituted or unsubstituted C₁-C₃₀ alkyl group, a substituted or unsubstituted C₁-C₃₀ alkoxy group, a substituted or unsubstituted C₂-C₃₀ alkenyl group, a substituted or unsubstituted C₂-C₃₀ alkynyl group, a substituted or unsubstituted C₆-C₃₀ aryl group, a substituted or unsubstituted C₃-C₃₀ heteroaryl group or a group represented by Formula -N(A₁)(A₂) where A₁ and A₂ are each independently a substituted or unsubstituted C₆-C₃₀ aryl group, or a substituted or unsubstituted C₃-C₃₀ heteroaryl group.

11. The organic light emitting device of claim 10, wherein R₁ through R₁₂ are each independently a hydrogen atom, a phenyl group, an (N,N-diphenyl)aminophenyl group, a naphthyl group, an anthracenyl group or an N-phenylcarbazolyl group.

12. The organic light emitting device of one of the preceding claims, further comprising a hole transport layer (20) between the red emissive layer (22R) and the first auxiliary layer (18R) and/or between the green emissive layer (22G) and the second auxiliary layer (18G).

13. The organic light emitting device of one of the preceding claims, further comprising at least one selected from the group consisting of an electron blocking layer, a hole blocking layer, an electron transport layer (24) and an electron injection layer (26).

14. The organic light emitting device of one of the preceding claims, adapted to induce a resonance between the first electrode (12) and the second electrode (28), when the organic light emitting device operates.
